# EUROPEAN PATENT SPECIFICATION

(11) **EP 0 415 620 B1**
(45) Date of publication and mention of the grant of the patent: **05.11.1997**
(21) Application number: 90309088.4
(22) Date of filing: 20.08.1990
(51) Int. Cl.: H03F 3/45

(54) **Electrical circuit**
Elektrische Schaltung
Circuit électrique

(30) Priority: 31.08.1989 US 401205
(43) Date of publication of application: 06.03.1991
(73) Proprietor: DELCO ELECTRONICS CORPORATION, Kokomo Indiana 46902 (US)
(72) Inventor: Kearney, Mark B., Kokomo, Indiana 46902 (US)
(74) Representative: Denton, Michael John

(56) References cited:
- US-A- 3 551 836
- SOVIET INVENTIONS ILLUSTRATED Section EI, week 8839, 9 nov 1988 Derwent Publications Ltd., London GB
- PATENT ABSTRACTS OF JAPAN vol. 12, no. 324 (E-653)(3171) 2 September 1988, & JP-A-63 87811 (MATSUSHITA ELECTRIC IND CO LTD) 19 April 1988,
- A. B. Grebene "BIPOLAR AND MOS ANALOG INTEGRATED CIRCUIT DESIGN", John Wiley & Sons, 1984, pages 387 to 391

## Description

The present invention relates to electrical circuits and, in the embodiment described, to an operational amplifier of the type comprising a folded cascode differential input stage wherein the bias or quiescent currents in the input stage are precisely controlled by a current mirror which senses the current in the output stage.

Folded cascade differential stages are useful for single-supply, low voltage, integrated circuit operational amplifiers for several reasons; which include the ability (i) to handle a wide common-mode input voltage range, (ii) to provide both voltage translation and differential to single-ended current conversion, and (iii) to operate over a wide range of supply voltages, together with being readily reduceable for incorporation into an integrated circuit.

In a prior art operational amplifier, for example US-4,525,663, the bias current levels are determined by a current source Iₛ connected to the input stage and a bias voltage VB connected to a differential to single-ended output stage. However, care must be taken in the generation of the current Iₛ because of the direct effect which variations in the current Iₛ have on the current I2 in the output stage. If the current Iₛ is too large, the current I2 may be reduced to zero. Conversely, if the current Iₛ is too low, the differential current in the input stage may not be large enough to be significant when compared to mismatch currents in the output stage. These conditions put upper and lower bounds on the current Iₛ relative to the current I2. Advantageously, the value of the current Iₛ should be equal to the desired value of the current I2. The current source of the current Iₛ is typically a "Wildar" current source which includes resistors, thereby making it difficult to maintain a precise relationship between the currents Iₛ and I2.

US-A-3551836 describes a differential amplifier circuit which similarly uses resistors to set the bias current in an input stage and the current drawn by diode-connected transistors. The circuit described does not provide equality between the input and output currents.

A.B. Grebene "Bipolar and MOS analog integrated circuit design" John Wiley & Sons, 1984, pages 387 to 391 discloses a circuit in accordance with the preamble of claim 1.

A circuit in accordance with the present invention is characterised over the prior art by those features defined in the characterising part of claim 1. This configuration allows the current I2 to be set as an independent value, preferably based only on the bias voltage VB and on resistors in the output stage.

An embodiment of the present invention is described below, by way of illustration only, with reference to the accompanying drawings, in which:
Figures 1a and 1b show circuit diagrams of prior art amplifiers; and
Figure 2 shows a circuit diagram of an embodiment of the present invention.

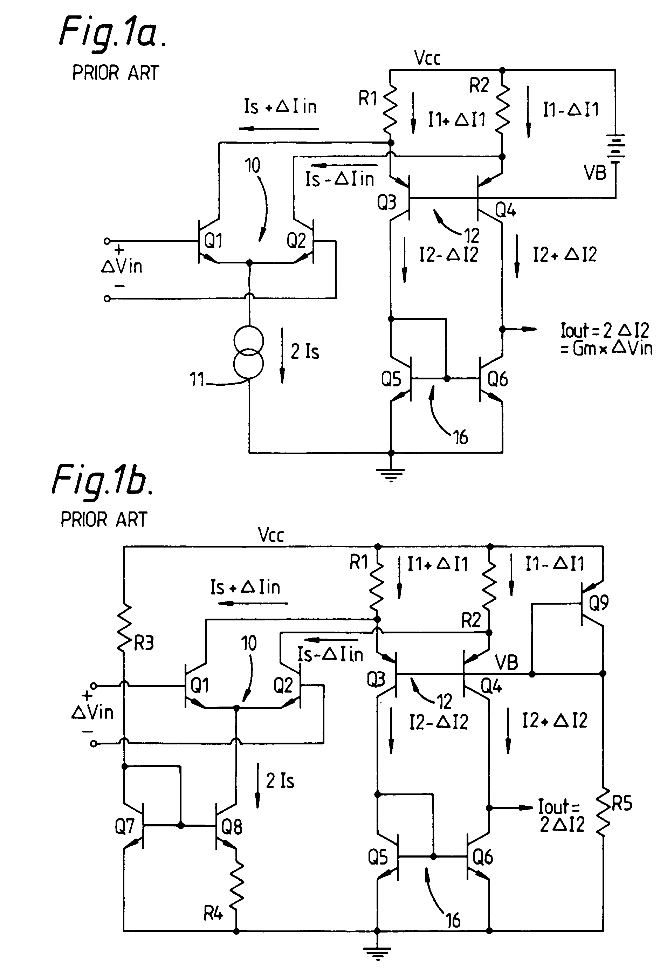

Referring to the prior art amplifier circuit shown in Figure 1a, a differential input voltage ΔVin is applied to an input stage, generally designated 10, which includes a common emitter differential transistor pair Q1 and Q2 biased by a current Is from current source 11. A differential current ΔIin results from the differential input voltage and appears in the currents passing through the collectors of the transistors Q1 and Q2. The currents passing through the transistors Q1 and Q2 are applied to the folded cascade stage, generally designated 12. The cascade stage 12 comprises a pair of equal-valued resistors R1 and R2 and two transistors Q3 and Q4. The action of the folded cascade stage 12 causes a differential current ΔI2 to appear in the collector currents of the transistors Q3 and Q4. These currents are applied to a current mirror, generally designated 16, formed by transistors Q5 and Q6, the action of which causes a differential to single-ended conversion at the output node, forcing a current of 2ΔI2 to be passed on to the next stage of the amplifier (not shown).

As will be apparent, the bias current levels in the circuit of Figure 1a are determined by the current source 2Is and a bias voltage source, VB. The transistors Q1 and Q2 divide the current 2Is equally, such that a current Is flows through each of the transistors when the differential input voltage ΔVin is zero. The currents in the transistors Q3 and Q4, represented in Figure 1a as I2, are then determined by subtracting the collector currents (Is) of the input stage Io from the currents flowing in the resistors R1 and R2. The currents in the resistors R1 and R2 are established by the voltage source VB minus the base-emitter diode drops of the transistors Q3 and Q4 and are represented in Figure 1a as I1.

An important parameter affecting the operation of a differential stage of this type is the overall transconductance, that is the ratio of the output current (ΔIout) to the differential input voltage (ΔVin). Evaluation of the small-signal node equations for the circuit of Figure 1a gives a result for the overall transconductance (Gm) as:$\text{Gm =} \frac{\text{ΔIout}}{\text{ΔVin}} \text{=} \frac{\text{R1}}{\text{re1}} \text{x} \frac{\text{1}}{\text{re3 + R1}}$ where: R1 = R2
re1 = re2 = dynamic emitter resistance of Q1 & Q2
re3 = re4 = dynamic emitter resistance of Q3 & Q4

The dynamic emitter resistance of a bipolar junction transistor is expressed as:$\text{re =} \frac{\text{k T}}{\text{q Ie}} \text{,}$ where
k = Boltzman's constant (1.38E-23 Joules/degree K),
T = absolute temperature (degrees Kelvin),
q = the charge of an electron (1.6E-19 coulomb), and
Ie is the emitter bias current of the transistor.

To maintain a constant overall transconductance over the amplifier's operating conditions, the dynamic emitter resistances (re's) of the transistors Q1 to Q4 must be controlled. Since the dynamic emitter resistances are established by the respective emitter bias current levels in each transistor, it is desirable that these currents are established in a predictable and repeatable fashion. It also follows, from the relationship for re in (2), that by making the emitter current of a transistor substantially proportional to absolute temperature, the variation in re over the operating temperature range of the device is minimized. This will then desensitize the overall transconductance Gm to temperature.

The circuit of Figure 1b shows a method of biasing the circuit such that the emitter currents are substantially proportional to absolute temperature so as to try to make the transconductance temperature independent. The trahsistors Q7 and Q8 and the resistors R3 and R4 form a "Widlar" current source for providing a current 2Is proportional to absolute temperature. The diode-connected transistor Q9 and the resistor R5 are used to generate the bias voltage VB. As long as the two currents Is in the differential amplifier stage 10 are maintained proportional to absolute temperature, it follows that the two currents I2 in the output stage 12 will also be proportional to absolute temperature. Use of a relatively low voltage for VB also improves the operation of the circuit at low voltages.

However, care must be taken in the generation of the current 2Is when the bias voltage VB is set to a diode drop below Vcc because of the direct effect which variations in the current Is have on the current I2. If the current Is is too large, the current I2 may be reduced to a very low value and the transconductance Gm will be affected. Conversely, if the current Is is too low, the differential current ΔI1 may not be large enough to be significant when compared to potential mismatch currents in the transistors Q3 and Q4. These conditions put upper and lower bounds on the current Is relative to the current I2. Advantageously, the value of the current Is is chosen to be equal to desired value of the current I2. While the "Widlar" current source of Figure 1b has the advantage of being able to generate small values for the current Is without using large resistor values, it makes it more difficult to maintain a precise relationship between the currents Is and I2.

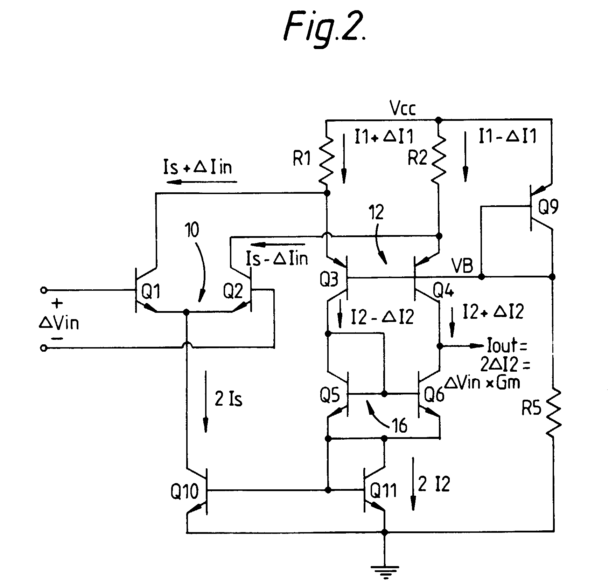

An embodiment of the present invention is shown in Figure 2, which solves the problem by providing means to force the current 2Is to a value equal to twice the value of the current I2, thereby allowing the current I2 to be set as an independent value based only on the bias voltage VB and on the value of the resistors R1 and R2. This is accomplished by summing the current I2 from the transistors Q5 and Q6 and generating a current of 2Is equal to the resultant summed current by means of a standard current mirror formed by the transistors Q10 and Q11. The advantage of this approach is that it allows the relationship between the currents Is and I2 to be maintained precisely by the current mirror, thereby allowing the current I2 to be established without concern for variations in the current Is. The resultant circuit also eliminates the need for resistors R3 and R4 of the circuit of Figure 1(b), resulting in a simpler overall circuit.

In the improved differential stage shown in Figure 2, the transistors Q10 and Q11 form a standard current mirror to generate the current Is from the sum of the two currents I2 as previously described. Since the current Is is equal to the current I2, the currents Il flowing in the resistors R1 and R2 are together equal to 2I2. Thus, all the currents may be properly established by choosing appropriate values for the resistors R1 and R2, and the voltage bias source VB.

It will be apparent that other forms of transistor may be used, with the relationship of collector, or input terminal; emitter, or output terminal; and base, or common terminal of each transistor being maintained.

## Claims

1. A circuit comprising a differential input stage (10) and a separate single ended output stage (12,16); bias means (Q9,R1,R2) for establishing bias currents in the input and output stages; a first current mirror (Q10,Q11) including an input current path (Q11) and an output current path (Q10); means for connecting the input current path to the output stage and for connecting the output current path to the input stage, whereby a bias current (Iₛ) in the input stage is controllable relative to a bias current (I2) in the output stage; characterised in that the input stage (10) comprises first and second transistors (Q1,Q2) arranged as a differential amplifier; in that the output stage comprises third and fourth transistors (Q3,Q4); in that a first resistor (R1) is connected between a voltage source (V_{cc}) and a terminal of the first transistor (Q1) and between the voltage source and a terminal of the third transistor (Q3); in that a second resistor (R2) connected between the voltage source and a terminal of the second transistor (Q2) and between the voltage source and a terminal of the fourth transistor (Q4); in that the bias means (Q9) is adapted to establish equal bias currents (I1) in the first and second resistors (R1,R2); in that the first current mirror comprises seventh and eighth transistors (Q10,Q11); in that the output stage comprises a second current mirror (16) including fifth and sixth transistors (Q5,Q6) connected to the third and fourth transistors (Q3,Q4); in that the eighth transistor (Q11) of the first current mirror is arranged as a diode and is connected to the second current mirror (16) for receiving the combined output currents of the third and fourth transistors (Q3,Q4); and in that the seventh transistor (Q10) is connected to the outputs of the first and second transistors (Q1,Q2).

## Patentansprüche

1. Schaltung mit einer Differenzeingangsstufe (10) und einer separaten einendigen Ausgangsstufe (12, 16); einem Vorspannungsmittel (Q9, R1, R2) zum Festsetzen von Vorspannungsströmen in der Eingangs- und Ausgangsstufe; einem ersten Stromspiegel (Q10, Q11) mit einem Eingangsstrompfad (Q11) und einem Ausgangsstrompfad (Q10); einem Mittel zum Verbinden des Eingangsstrompfads mit der Ausgangsstufe und zum Verbinden des Ausgangsstrompfads mit der Eingangsstufe, wodurch ein Vorspannungsstrom (Iₛ) in der Eingangsstufe in Bezug zu einem Vorspannungsstrom (I2) in der Ausgangsstufe steuerbar ist;
dadurch **gekennzeichnet**,
daß die Eingangsstufe (10) erste und zweite Transistoren (Q1, Q2) aufweist, die als ein Differenzverstärker angeordnet sind; daß die Ausgangsstufe dritte und vierte Transistoren (Q3, Q4) aufweist; daß ein erster Widerstand (R1) zwischen eine Spannungsquelle (V_{cc}) und eine Klemme des ersten Transistors (Q1) und zwischen die Spannungsquelle und eine Klemme des dritten Transistors (Q3) geschaltet ist; daß ein zweiter Widerstand (R2) zwischen die Spannungsquelle und eine Klemme des zweiten Transistors (Q2) und zwischen die Spannungsquelle und eine Klemme des vierten Transistors (Q4) geschaltet ist; daß das Vorspannungsmittel (Q9) angepaßt ist, um gleiche Vorspannungsströme (I1) in dem ersten und zweiten Widerstand (R1, R2) festzusetzen; daß der erste Stromspiegel einen siebten und achten Transistor (Q10, Q11) aufweist; daß die Ausgangsstufe einen zweiten Stromspiegel (16) aufweist, der einen fünften und sechsten Transistor (Q5, Q6) aufweist, die mit dem dritten und vierten Transistor (Q3, Q4) verbunden sind; daß der achte Transistor (Q11) des ersten Stromspiegels als eine Diode angeordnet ist und mit dem zweiten Stromspiegel (16) zum Empfangen der kombinierten Ausgangsströme des dritten und vierten Transistors (Q3, Q4) verbunden ist; und daß der siebte Transistor (Q10) mit den Ausgängen des ersten und zweiten Transistors (Q1, Q2) verbunden ist.

## Revendications

1. Circuit comprenant une étage différentiel d'entrée (10) et un étage asymétrique de sortie (12, 16) ; des moyens de polarisation (Q9, R1, R2) pour établir des courants de polarisation dans les étages d'entrée et de sortie ; un premier miroir de courant (Q10, Q11) comprenant un trajet de courant d'entrée (Q11) et un trajet de courant de sortie (Q10) ; des moyens pour relier le trajet de courant d'entrée à l'étage de sortie et pour relier le trajet de courant de sortie à l'étage d'entrée, afin qu'un courant de polarisation (Iₛ) dans l'étage d'entrée puisse ainsi être commandé par rapport à un courant de polarisation (I2) dans l'étage de sortie ; caractérisé en ce que l'étage d'entrée (10) comprend des premier et deuxième transistors (Q1, Q2) agencés en amplificateur différentiel ; en ce que l'étage de sortie comprend des troisième et quatrième transistors (Q3, Q4) ; en ce qu'une première résistance (R1) est branchée entre une source de tension (V_{cc}) et une borne du premier transistor (Q1) et entre la source de tension et une borne du troisième transistor (Q3) ; en ce qu'une deuxième résistance (R2) est branchée entre la source de tension (V_{cc}) et une borne du deuxième transistor (Q2) et entre la source de tension et une borne du quatrième transistor (Q4) ; en ce que les moyens de polarisation (Q9) sont conçus pour rendre égaux les courants de polarisation (I1) dans les première et deuxième résistances (R1, R2) ; en ce que le premier miroir de courant comprend des septième et huitième transistors (Q10, Q11) ; en ce que l'étage de sortie comprend un deuxième miroir de courant (16) comprenant des cinquième et sixième transistors (Q5, Q6) reliés aux troisième et quatrième transistors (Q3, Q4) ; en ce que le huitième transistor (Q11) du premier miroir de courant est agencé en diode et est relié au deuxième miroir de courant (16) pour recevoir les courants combinés de sortie des troisième et quatrième transistors (Q3, Q4) ; et en ce que le septième transistor (Q10) est relié aux sorties des premier et deuxième transistors (Q1, Q2).
